# EUROPEAN PATENT SPECIFICATION

(11) **EP 0 259 925 B1**
(45) Date of publication and mention of the grant of the patent: **09.06.1993**
(21) Application number: 87201675.3
(22) Date of filing: 04.09.1987
(51) Int. Cl.: B21D 39/03, H01H 85/143

(54) **A method of interconnecting metal strips for use in electrical components, and electrical component comprising strips thus interconnected**
Verfahren zum Verbinden metallischer Streifen beim Herstellen von elektrischen Bestandteilen und Bestandteile mit solchen Streifen
Procédé d'interconnexion des bandes de métal dans la fabrication de composants électriques et composant électrique comportant des bandes ainsi reliées

(30) Priority: 05.09.1986 NL 8602251
(43) Date of publication of application: 16.03.1988
(73) Proprietor: Littelfuse Tracor B.V., 3531 BM Utrecht (NL)
(72) Inventor: de Kler, Dirk, NL-1231 CA Loosdrecht (NL); Vermij, Leendert, NL-4116 CG Buren (NL)
(74) Representative: Smulders, Theodorus A.H.J., Ir.

(56) References cited:
- EP-A- 0 155 618
- CH-A- 402 518
- DE-B- 1 297 206
- FR-A- 1 538 218
- GB-A- 1 202 926
- US-A- 2 715 169
- US-A- 3 130 489

## Description

This invention relates to a method of interconnecting metal strips for use in electrical components, wherein in one of the strips a recessed portion is formed and the other strip is placed on or over the recessed strip and subsequently a punch is pressed over and on the other strip and the recessed portion, using a punch whose dimensions are in excess of the dimensions of the recessed portion and whose shape is such that a groove is formed in said one strip at some distance from the edge of the recessed portion.

Such method is known from US-A-2,715,169. Said reference discloses a method for fabricating a switch contact of the type in which a disk of material having favorable contact characteristics is inlaid in and clamped in a flat holder. In the known method the contact disk has a convaco-convex shape and has a frusto-conical peripheral wall. By means of the punch the metal of a bead completely surrounding the contact disk is deformed plastically such that the disk is secured in place.

An object of the present invention is to provide a general method to interconnect metal strips by means of which a very good connection with reproducible characteristics is effected between two metal strips. Such object is achieved by a method in which in an extrusion riveting technique said recessed portion is formed wider than the width of the portion of the other strip that is placed in or over the recessed portion, said recessed portion being substantially as deep as the other strip is thick, said other strip being flat and being placed such that only an end portion of said other strip lies within the recessed portion or only an intermediate portion of said other strip lies fittingly right over the recessed portion, said punch being such that the edges which engage the material of said one strip alongside the recessed portion are sharp edges which stand proud of a central portion of the punch, so that material from said one strip is extruded on to and overlapping the upper edge of the portion of the other strip in the recessed portion.

Unlike welding or soldering, an extrusion riveting technique produces a well-definable place of the connection. Electrical components made by the method of the present invention have been found to have well-determinable characteristics.

It has to be remarked that in EP-A-0,155,618 a method of interconnecting metal sheets is described whereby the strips to be interconnected are firmly interconnected by means of an extrusion riveting techique.

The invention is illustrated in and by the following description, read with reference to the accompanying drawings, in which
Fig. 1A is a top plan view and Fig. 1B a front-elevational view of a set of metal strips to be interconnected;
Fig. 2A is a top plan view and Fig. 2B a front-elevational view of a different set of strips to be interconnected;
Fig. 3 is a cross-sectional view of a set of strips to be interconnected during the application of one embodiment of the method according to the present invention;
Figs. 4A-4E are top plan views and front-elevational views of a set of strips to be interconnected in various stages of application of such other embodiment of the method according to the present invention; and
Figs. 5A-5C are views similar to Fig. 4, in which various stages of a variant of the method according to the invention are shown.

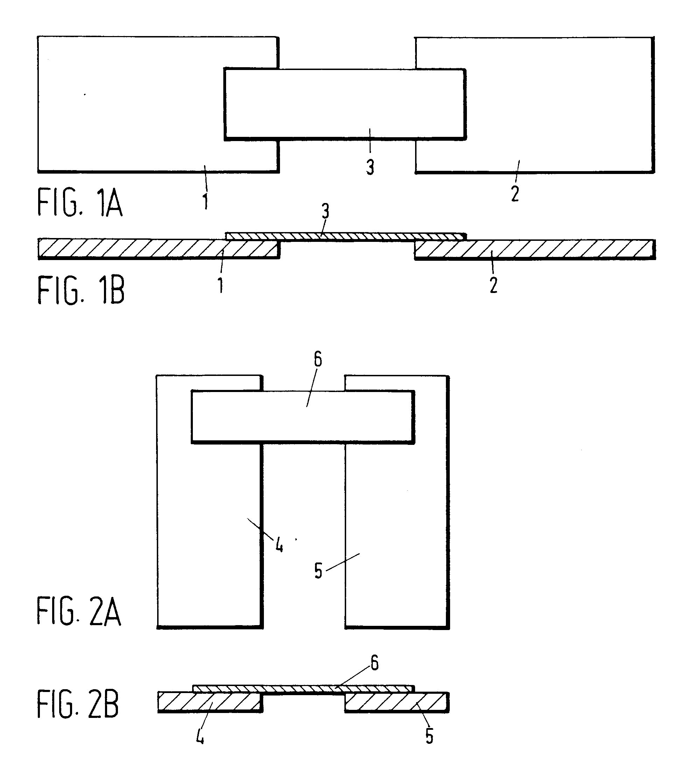

Fig. 1 illustrates a pair of metal strips 1 and 2, to be interconnected by means of the metal strip 3. Similarly, Fig. 2 shows metal strips 4 and 5 to be interconnected by means of metal strip 6. A connection of the type shown in Figs. 1 and 2 occurs frequently in electrical components, for example, in fuses, in which the connecting strip may be the actual fuse element, and the strips to be connected the contact blades of the fuse. The strips may have many forms, as already shown in Figs. 1 and 2, and the nature of the metal of the strips may be the same or different. The only important point is that the connection between each pair of strips should be very reliable in the sense that it is often desirable that only a negligible energy dissipation occurs at the actual connecting point when a current passes through it and that the electrical and mechanical characteristics of the connection remain essentially constant during a long period of functioning, during which all sorts of electrical, mechanical, thermal and chemical effects may assert themselves. Furthermore, it is desirable that the connection should be such as to enable automated production in large quantities at low cost.

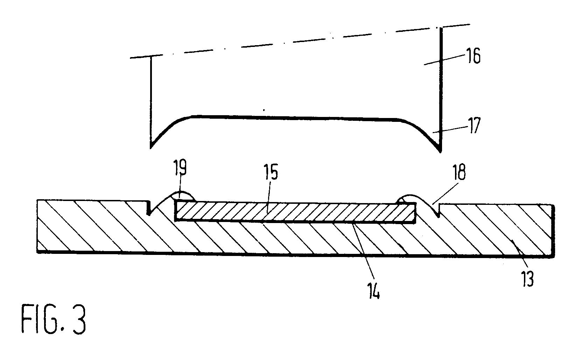

According to the present invention, the above requirements are met by an extrusion riveting technique. An embodiment thereof is illustrated in Fig. 3. In that embodiment, first a recessed portion 14 is formed in a metal strip 13 by means of a suitable punch. In the recessed portion 14, a part of the strip 15, to be connected with strip 13, is laid. The recessed portion 14 is shaped so that it virtually fits the portion of strip 15 placed in it. Subsequently, pressure is exerted on the material of strip 13 around the recessed portion 14 and the strip 15 placed therein by means of a punch 16. For this purpose, punch 16 is shaped so as to extend laterally beyond the edge of strip 15 and the recessed portion 14. The edges 17 of punch 16 are relatively sharp and stand proud of the central portion of punch 16.

By pressing punch 16 into contact with strip 13, the sharp edges 17 form a groove 18 in strip 13 around the recessed portion 14, and material from strip 13 is extruded to form a ridge 19 on to strip 15 along the periphery thereof as far as adjoined by groove 18. There is thus produced a very good connection between strips 13 and 15 with reproducible electrical and mechanical characteristics.

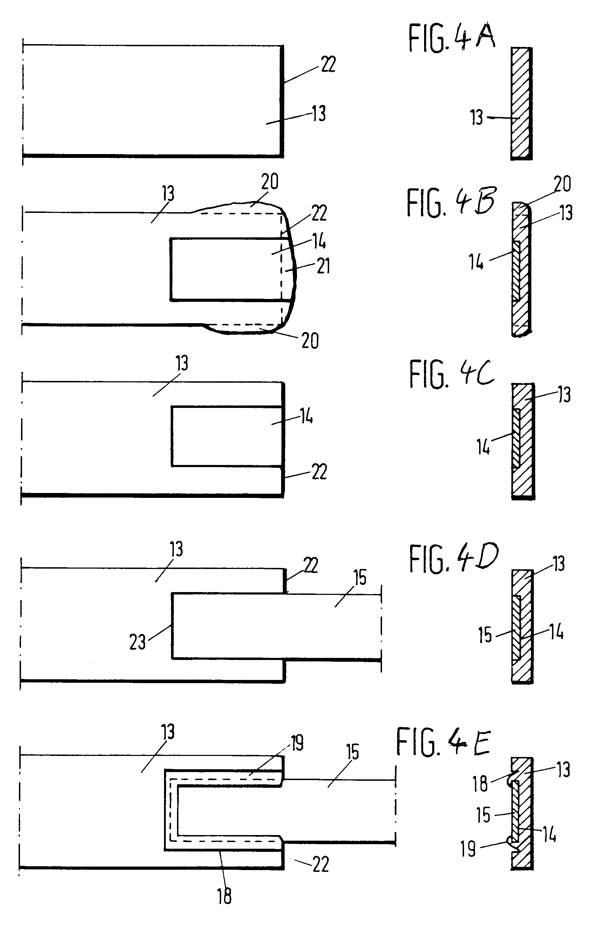

The various stages of the embodiment of the method according to the invention described with reference to Fig. 3 will now be described in more detail with reference to Figs. 4A-4E, which each comprise a plan view (on the left-hand side of the figure) and a cross-sectional view (on the right-hand side). Fig. 4A shows a starting strip 13. Using a suitable punch, a recessed portion 14 which on one side adjoins the front edge 22 of strip 13 is formed, whereby some material is displaced and strip 13 becomes somewhat distorted, as illustrated in Fig. 4B. Excess material 20 projects beyond the original edge on the sides, and excess material 21 projects beyond the original edge 22 of strip 13 at the front. The original edges are shown in dash lines in Fig. 4B.

The excess material 20 and 21 is trimmed, resulting in strip 13 with a recessed portion 14 as illustrated in Fig. 4C. Subsequently, strip 15, to be connected to strip 13 is laid within the recessed portion 14, as shown in Fig. 4D, so that the front edge of strip 15 lies virtually into contact with the rear edge 23 of the recessed portion 14.

Subsequently a punch is used as described with reference to Fig. 3. The punch is provided with a sharp edge on three sides, so that, in the manner shown in Fig. 4E, a ridge 19 is formed over the edges of strip 15 shown in ghost outline on three sides.

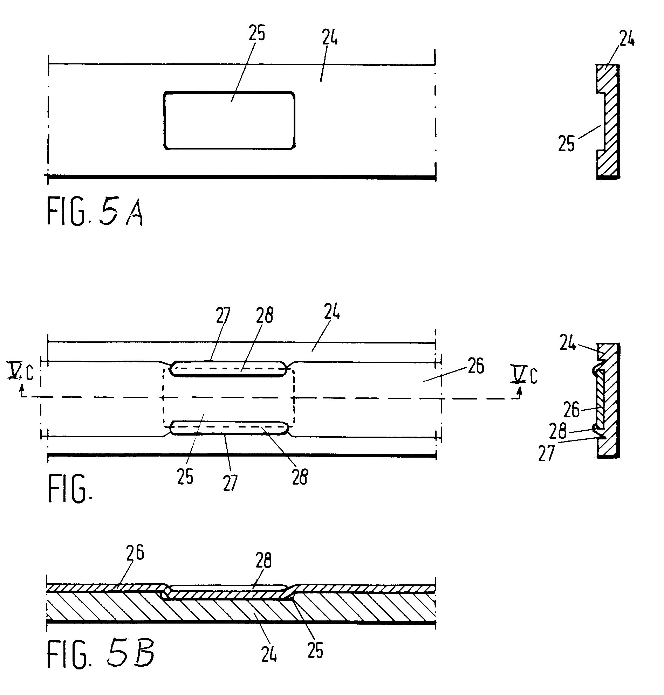

Figs. 5A-5C illustrate a variant of the last-described embodiment of the method according to the present invention. Figs. 5A and 5B show some stages in plan view (on the left-hand side) and in cross-sectional view (on the right-hand side), while Fig. 5C is a longitudinal section taken on the line VC-VC of Fig. 5B.

Fig. 5A illustrates a metal strip 24 in which a recessed portion 25 has been formed in the middle by means of a suitable punch. Subsequently a strip 26 is laid on top of strip 24. The portion of strip 26 overlying the recessed portion 25 has a width matching the width of the recessed portion 25. Naturally, a strip 26 may be selected which has a width adapted to the recessed portion 25 throughout. In the present case, as shown in Fig. 5B, a strip 26 with a reduced portion has been selected.

Using a punch with sharp edges parallel to the long sides of strip 26, material from strip 24 is extruded so that grooves 27 are formed alongside the long sides adjacent to the sides of the recessed portion 25, and ridges 28 of the material from strip 24 are formed to overlie the edges of the reduced portion of strip 26, which at the same time is pressed into the recessed portion 25.

## Claims

1. A method of interconnecting metal strips (13, 15; 24, 26) for use in electrical components, wherein in one of the strips (13, 24) a recessed portion (14, 25) is formed and the other strip (15, 26) is placed on or over the recessed strip and subsequently a punch (16) is pressed over and on the other strip and the recessed portion, using a punch (16) whose dimensions are in excess of the dimensions of the recessed portion (14, 25) and whose shape is such that a groove (18, 27) is formed in said one strip (13, 24) at some distance from the edge of the recessed portion (14, 25), characterized in that in an extrusion riveting technique said recessed portion (14, 25) is formed wider than the width of the portion of the other strip that is placed in or over the recessed portion, said recessed portion being substantially as deep as the other strip is thick, said other strip (15, 26) being flat and being placed such that only an end portion of said other strip lies within the recessed portion or only an intermediate portion of said other strip (26) lies fittingly right over the recessed portion (25), said punch (16) being such that the edges which engage the material of said one strip alongside the recessed portion (14, 25) are sharp edges (17) which stand proud of a central portion of the punch (16), so that material (19, 28) from said one strip (13, 24) is extruded on to and overlapping the upper edge of the portion of the other strip (15, 26) in the recessed portion (14, 25).

## Patentansprüche

1. Verfahren zum Verbinden metallischer Streifen (13, 15; 24, 26) zur Verwendung in elektrischen Bauteilen, wobei in einem der Streifen (13, 24) eine Ausnehmung (14, 25) gebildet wird und der andere Streifen (15, 26) auf bzw. über dem mit der Ausnehmung versehenen Streifen angeordnet wird und anschließend ein Stempel (16) über bzw. auf den anderen Streifen und die Ausnehmung gepreßt wird, wobei ein Stempel (16) verwendet wird, dessen Abmessungen größer sind als die der Ausnehmung (14, 25) und der so ausgebildet ist, daß in dem einen Streifen (13, 24) eine vom Rand der Ausnehmung (14, 25) beabstandete Nut (18, 27) gebildet wird,
dadurch gekennzeichnet, daß
die Ausnehmung (14, 25) in einem Preß-Nietverfahren breiter ausgebildet wird als der Bereich des anderen Streifens, der in oder über der Ausnehmung angeordnet wird,
daß die Tiefe der Ausnehmung im wesentlichen der Dicke des anderen Streifens entspricht,
daß der andere Streifen (15, 26) flach ausgebildet ist und derart angeordnet wird, daß nur ein Endbereich des anderen Streifens in der Ausnehmung liegt oder nur ein Zwischenbereich des anderen Streifens (26) passend genau über der Ausnehmung (25) liegt,
daß der Stempel (16) derart ausgebildet ist, daß die Kanten (17), die das Material des einen Streifens entlang der Ausnehmung (14, 25) beaufschlagen, scharf ausgebildet sind und gegenüber einem Mittelteil des Stempels (16) hervorragen, so daß Material (19, 28) von dem einen Streifen (13, 24) derart auf den oberen Randbereich des in der Ausnehmung (14, 25) angeordneten anderen Streifens (15, 26) gepreßt wird, daß er diesen überlappt.

## Revendications

1. Procédé pour interconnecter des bandes de métal (13, 15; 24, 26) devant être utilisées dans des composants électriques, selon lequel l'on forme une partie évidée (14, 25) dans l'une des bandes (13, 24) et l'autre bande (15, 26) est placée sur, ou au-dessus de la bande évidée et ensuite un poinçon (16) est appliqué dessus et sur l'autre bande et la partie évidée, en utilisant un poinçon (16) dont les dimensions excèdent les dimensions de la partie évidée (14, 25) et dont la forme est telle qu'une rainure (18, 27) est formée dans ladite bande (13, 24) à une certaine distance du bord de la partie évidée (14, 25) caractérisé en ce que, par une technique de rivetage par extrusion, ladite partie évidée (14, 25) est formée avec une largeur plus importante que la largeur de la partie de l'autre bande qui est placée dans ou sur la partie évidée, ladite partie évidée étant sensiblement aussi profonde que l'autre bande est épaissse, ladite autre bande (15, 26) étant plate et étant placée de telle manière qu'une partie d'extrémité seulement de ladite autre bande soit située dans la partie évidée ou seulement une partie intermédiaire de ladite autre bande (26) soit située, en s'y adaptant, juste au-dessus de la partie évidée (25), ledit poinçon (16) étant tel que les bords qui sont en prise avec le matériau de ladite bande, le long de la partie évidée (14, 25) présentent des bords vifs (17) qui font saillie d'une partie centrale de poinçon (16), afin que le matériau (19, 28) de ladite bande (13, 24) soit extrudé vers, et recouvre, le bord supérieur de la partie de l'autre bande (15, 26) dans la partie évidée (14, 25).
